# EUROPEAN PATENT APPLICATION

(11) **EP 4 470 688 A1**
(43) Date of publication of application: **04.12.2024**
(21) Application number: 22924190.6
(22) Date of filing: 23.12.2022
(51) Int. Cl.: B09B 5/00, B09B 3/35, B09B 101/15

(54) **PHOTOELECTRIC CONVERSION PANEL MATERIAL RECOVERY METHOD AND MATERIAL RECOVERY SYSTEM FOR PHOTOELECTRIC CONVERSION PANELS**

(30) Priority: 28.01.2022 JP 2022011587
(71) Applicant: Solar Frontier K.K., Tokyo 100-0005 (JP)
(72) Inventor: HARADA, Hideki, Tokyo 100-0005 (JP)
(74) Representative: Hoffmann Eitle
(86) International application number: PCT/JP2022/047552
(87) International publication number: WO 2023/145343

(57) **Abstract**

Provided is a novel material collection method for collecting a material from a photoelectric conversion panel without using an etching solution. The method for collecting a material from a photoelectric conversion panel, comprises: a crushing step (S3) of forming a crushed material by crushing a structure constituting a photoelectric conversion panel; and a specific gravity sorting step (S5) of sorting the crushed material into a first specific gravity material having at least a first specific gravity and a high specific gravity material having a specific gravity larger than the first specific gravity on a basis of specific gravity.

## Description

### Technical Field

The present invention relates to a material collection method and a material collection system for collecting a material constituting, for example, a photoelectric conversion panel such as a solar cell panel.

### Background Art

In recent years, a technique for recycling used objects as resources has been known from the viewpoint of resource utilization and environmental protection. For example, a photoelectric conversion module such as a solar cell module installed on a roof of a building such as a house is rapidly spreading in recent years. For this reason, it is desirable to develop a technique for recycling a photoelectric conversion module.

Patent Literature 1 below discloses a method for collecting metal contained in a battery layer from a battery cell portion of a solar cell module. In Patent Literature 1, a metal material constituting the battery layer is dissolved in a nitric acid solution and collected in a state of being dissolved in a solution.

### Citation List

### Patent Literature

Patent Literature 1: WO 2019/203026 A

### Summary

In recycling a photoelectric conversion panel, a metal is immersed in an etching solution such as a nitric acid solution to be eluted, and the eluted metal may be sold. However, the metal in a state of being eluted in an etching solution such as a nitric acid solution may have low material usability.

Therefore, a novel material collection method and a novel material collection system for collecting a material from a photoelectric conversion panel without using an etching solution are desired.

In one aspect, a method for collecting a material from a photoelectric conversion panel, comprises: a crushing step of forming a crushed material by crushing a structure constituting a photoelectric conversion panel; and a specific gravity sorting step of sorting the crushed material into a first specific gravity material having at least a first specific gravity and a high specific gravity material having a specific gravity larger than the first specific gravity on a basis of specific gravity.

In one aspect, a system for collecting a material from a photoelectric conversion panel, comprises: a crushing unit that is configured to form a crushed material by crushing a structure constituting a photoelectric conversion panel; and a specific gravity sorting unit that is configured to sort the crushed material into a first specific gravity material having at least a first specific gravity and a high specific gravity material having a specific gravity larger than the first specific gravity on a basis of specific gravity.

### Brief Description of Drawings

Fig. 1 is a schematic cross-sectional view of a photoelectric conversion module according to an embodiment.
Fig. 2 is a schematic enlarged view in which a part of a photoelectric conversion element according to an embodiment is enlarged.
Fig. 3 is a schematic view of a system for collecting a material from a photoelectric conversion panel according to an embodiment.
Fig. 4 is a schematic side view of a specific gravity sorting unit according to an embodiment.
Fig. 5 is a schematic top view of the specific gravity sorting unit according to an embodiment.
Fig. 6 is a flowchart of a method for collecting a material from a photoelectric conversion panel according to an embodiment.

### Description of Embodiments

Hereinafter, embodiments will be described with reference to the drawings. In the following drawings, the same or similar parts are denoted by the same or similar reference numerals. However, it should be noted that the drawings are schematic, and ratios of dimensions and the like may be different from actual ones.

### [Configuration of Photoelectric Conversion Module]

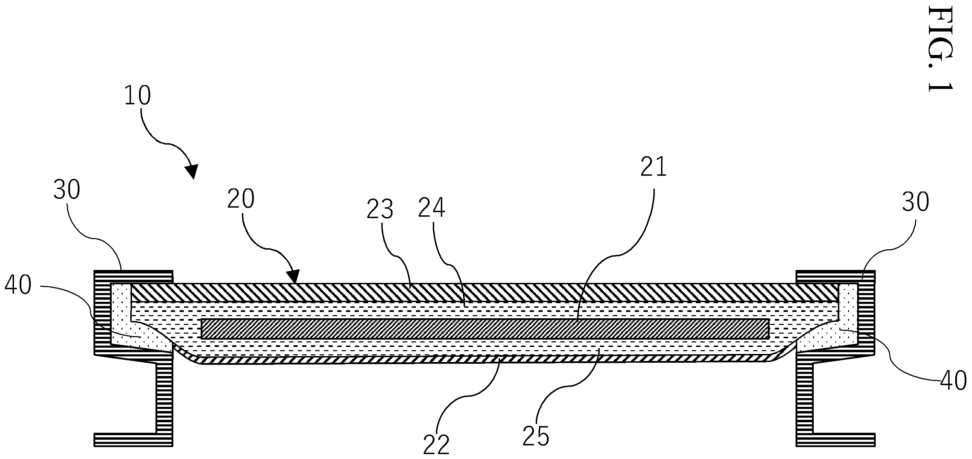

First, an example of a configuration of a photoelectric conversion module that can be recycled will be described. Fig. 1 is a schematic cross-sectional view of a photoelectric conversion module according to an embodiment.

In the example illustrated in Fig. 1, a photoelectric conversion module 10 includes a photoelectric conversion panel 20 and a frame 30 surrounding an outer edge of the photoelectric conversion panel 20. A junction box and an output cable (not illustrated) serving as a power extraction port may be attached to the back surface of the photoelectric conversion module 10.

A sealing material 40 may be provided between the photoelectric conversion panel 20 and the frame 30. The material constituting the sealing material 40 is not particularly limited, and examples thereof include a polyethylene resin, a fluorine resin, a polystyrene resin, a polyolefin resin, a silicone resin, and a butyl rubber.

The photoelectric conversion panel 20 may include a photoelectric conversion element 21, a rear protective layer 22, a cover glass 23, a first sealing layer 24, and a second sealing layer 25. The cover glass 23 may be, for example, a transparent or translucent glass layer. The glass layer may be constituted by, for example, tempered glass.

The first sealing layer 24 is provided between the photoelectric conversion element 21 and the cover glass 23. Examples of the material constituting the first sealing layer 24 include an ethylene-vinyl acetate resin, a polyethylene resin, a fluorine resin, a polystyrene resin, a polyolefin resin, a silicone resin, and a butyl rubber.

The second sealing layer 25 is provided between the photoelectric conversion element 21 and the rear protective layer 22. The material constituting the second sealing layer 25 is not particularly limited, and examples thereof include an ethylene-vinyl acetate resin, a polyethylene resin, a fluorine resin, a polystyrene resin, a polyolefin resin, a silicone resin, and a butyl rubber.

The rear protective layer 22 is a protective layer that covers a back side of the photoelectric conversion panel 20. The rear protective layer 22 is provided on the back side of the second sealing layer 25. The material constituting the rear protective layer 22 may be, for example, a PET resin, a polyvinyl fluoride (PVF) resin, a polyvinylidene fluoride (PVDF) resin, a nylon resin, a polyamide resin, or a combination thereof. Alternatively, the rear protective layer 22 may be constituted by a metal sheet.

The photoelectric conversion element 21 is an element that converts light energy into electric energy. The photoelectric conversion element 21 may have any configuration capable of converting light energy into electric energy. Examples of such an element include a crystalline photoelectric conversion element and a thin-film CIS photoelectric conversion element. Many crystalline photoelectric conversion elements have a structure using semiconductor silicon as a substrate. Specifically, the crystalline silicon photoelectric conversion element includes a plurality of battery cell portions constituted by a silicon substrate. A battery cell portion contains a metal material such as copper or silver as an electrode material or wiring.

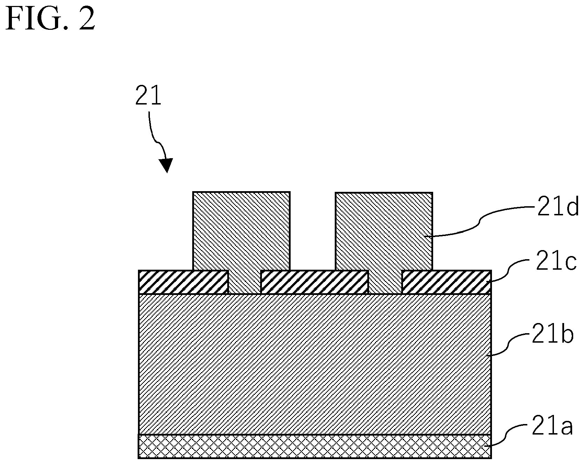

Fig. 2 is a schematic enlarged view in which a part of a photoelectric conversion element according to an embodiment is enlarged. Fig. 2 illustrates a part of a photoelectric conversion element having what is called a crystalline silicon. The photoelectric conversion element 21 includes a back electrode layer 21a, a silicon crystal layer 21b, an antireflection film 21c, and an electrode 21d. The silicon crystal layer 21b may include an n-type layer or a p-type layer.

The antireflection film 21c is provided on a front surface side of the silicon crystal layer 21b. The antireflection film 21c may contain, for example, SiO₂, SiN and/or TiO₂. The electrode 21d is disposed on a front surface side of the antireflection film 21c. The electrode 21d may contain, for example, silver.

### [System For Collecting Material]

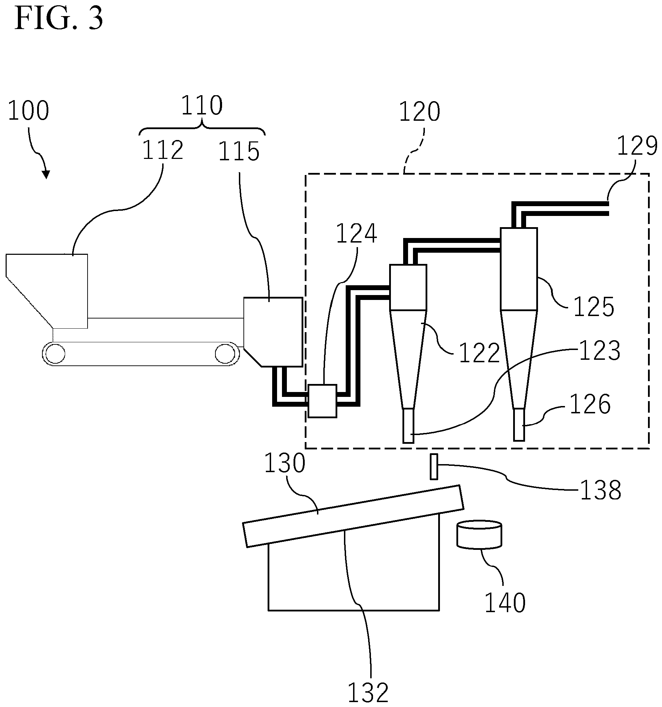

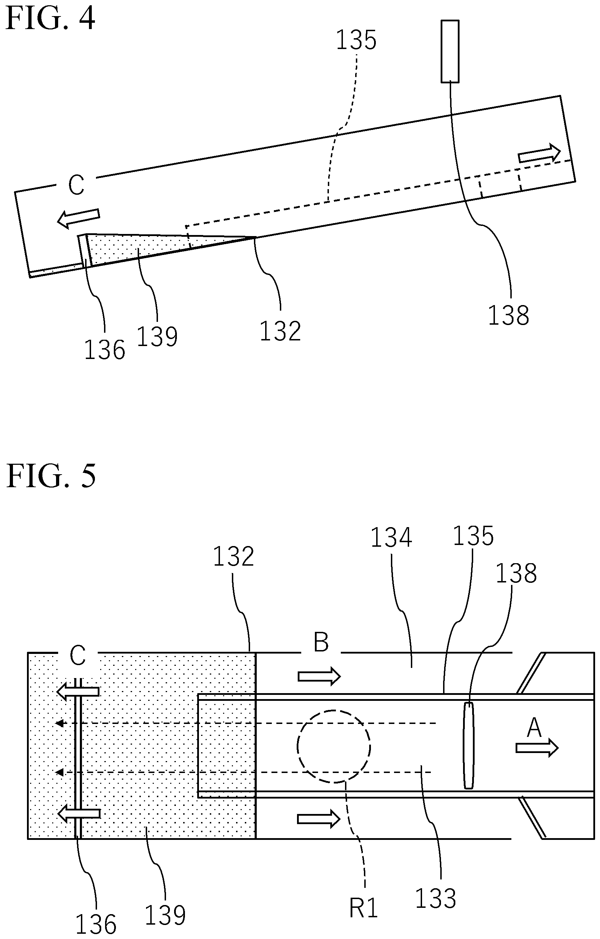

A system for collecting material according to an embodiment will be described with reference to Figs. 3 to 5. Fig. 3 is a schematic view of a system for collecting material from a photoelectric conversion panel according to the embodiment. Fig. 4 is a schematic side view of a specific gravity sorting unit according to the embodiment. Fig. 5 is a schematic top view of the specific gravity sorting unit according to the embodiment.

A system 100 for collecting material from a photoelectric conversion panel can be used as a system for collecting a material from the above-mentioned photoelectric conversion panel 20. Preferably, the system 100 for collecting material may be a system for collecting a material from the photoelectric conversion panel 20 including silicon (including silicon compounds, the same shall apply hereinafter). The material collection system 100 may process, for example, a structure obtained by removing a glass layer such as a cover glass from the photoelectric conversion panel 20.

The material collection system 100 may include a crushing unit 110, a wind power sorting unit 120, a specific gravity sorting unit 130, and a drying unit 140.

The crushing unit 110 may have any structure as long as the structure constituting the photoelectric conversion panel 20 can be crushed. The crushing unit 110 crushes a structure constituting the photoelectric conversion panel to form a crushed material. The crushing unit 110 may preferably pulverize the structure constituting the photoelectric conversion panel until the structure becomes small-diameter particles. The structure constituting the photoelectric conversion panel 20 to be crushed may be the photoelectric conversion panel 20 itself or a structure obtained by removing the glass layer from the photoelectric conversion panel 20.

The crushing unit 110 may include a first crushing unit 112 and a second crushing unit 115. The first crushing unit 112 may be, for example, a uniaxial crusher that has a bit-like blade on a rotating shaft and continuously crushes a structure while biting the structure with a fixed blade, a biaxial crusher that has a large shear stress due to a structure in which a workpiece is sandwiched between rotating blades, or a vertical crusher that continuously crushes the workpiece until the workpiece becomes equal to or smaller than a desired size while being hit by a high-speed rotating hammer. Preferably, the first crushing unit 112 may be a uniaxial crusher having a bid-like crushing tooth which is excellent in shape control of the workpiece with respect to the second crushing unit 115 arranged more subsequently and does not shear and crush the structure.

The second crushing unit 115 may be, for example, a uniaxial crusher that cuts with a rotary blade having a wide blade width and a fixed blade, or a shredder type biaxial crusher. The second crushing unit 115 may crush the workpiece pulverized by the first crushing unit 112 into particles having a smaller diameter. Preferably, the second crushing unit 115 is a uniaxial crusher that cuts with a fixed blade and a rotary blade having a wide blade width. Accordingly, in a case where the photoelectric conversion panel includes a photoelectric conversion element having crystalline silicon, it is possible to more efficiently peel off a first sealing layer 24 and a second sealing layer 25 from the photoelectric conversion element 21, and to separate and pulverize the antireflection film 21c of the photoelectric conversion element 21 and the silicon crystal layer 21b.

The second crushing unit 115 may be, for example, a die type crusher having a disk-shaped rotatable upper plate and/or lower plate facing each other. In this case, the shear stress can be applied to the workpiece by applying a mechanical force to the workpiece with the workpiece sandwiched between the rotating upper plate and lower plate. Thus, the first sealing layer 24 and the second sealing layer 25 can be more efficiently peeled from the photoelectric conversion element 21, and the antireflection film 21c and the silicon crystal layer 21b of the photoelectric conversion element 21 can be separated and pulverized.

In the illustrated configuration, the crushing unit 110 includes a first crushing unit 112 and a second crushing unit 115. Alternatively, the crushing unit 110 may include only one of the first crushing unit 112 and the second crushing unit 115 if possible. In addition, the crushing unit 110 may include three or more kinds of crushing units.

The wind power sorting unit 120 may include an accommodation space 122 and a wind power generator 124. Preferably, the wind power sorting unit 120 may be a cyclone-type wind power sorter that causes a spiral wind in the accommodation space 122. A cyclone-type wind power sorter may be configured to sort a material having a smaller particle size from the crushed material crushed by the crushing unit 110.

The wind power sorting unit 120 sorts the crushed material crushed by the crushing unit 110 by wind power on the basis of the weight and volume of the material in the crushed material. Preferably, the wind power sorting unit 120 sorts the crushed material crushed by the crushing unit 110, by wind power, into a first material group which has a relatively large particle size and specific gravity and a second material group which has a relatively small particle size (powder state). Specifically, the first material group is constituted by a crushed material that has not been blown away by a desired wind power. On the other hand, the second material group is constituted by a crushed material that has blown by a desired wind power. Here, the first material group is a material group used in a specific gravity sorting unit to be described later, and the second material group is a material group not used in the specific gravity sorting unit.

The wind power sorting unit 120 sorts the crushed material on the basis of mainly weight and volume. Therefore, a relatively light and small volume material can be collected from the materials contained in the photoelectric conversion panel. Thus, in the case of the silicon-based photoelectric conversion panel, the second material group sorted by the wind power sorting unit 120 may mainly contain powdery silicon and the sealing material in the crushed material.

The wind power sorting unit 120 may be located between the crushing unit 110 and the specific gravity sorting unit 130. The crushed material crushed by the crushing unit 110 is carried into the accommodation space 122 by a wind emitted from the wind power generator 124. The first material group of the crushed material that has not been blown away by a desired wind power is sent to the specific gravity sorting unit 130 through an outlet 123 located at a bottom of the accommodation space 122. The second material group blown away by the wind is sent from a top of the accommodation space 122 to a second accommodation space 125 arranged at the subsequent stage, and then is collected from an outlet 126 located at a bottom of the second accommodation space 125 if necessary.

In addition, the wind power sorting unit 120 may include an exhaust port 129 communicating from the top of the second accommodation space 125.

The specific gravity sorting unit 130 may include a stage 132 capable of vibrating, a motor (not illustrated) that vibrates the stage 132, and an ejection port 138 that ejects liquid. In the present embodiment, the stage 132 is provided to be inclined in one direction. The ejection port 138 ejects liquid for sorting a material in the crushed material on the basis of a difference in sedimentation behavior. The liquid may be, for example, water. The ejection port 138 is disposed at a position where liquid can be ejected on an inclined stage.

Preferably, a first passage 133 and a second passage 134 are formed on the stage 132. A partition 135 is formed between the first passage 133 and the second passage 134. The first passage 133 and the second passage 134 communicate with each other on a downstream side of the partition 135. In this case, the ejection port 138 is preferably disposed so as to generate a relatively strong liquid flow in the first passage 133 of the inclined stage 132.

In the present embodiment, a weir 136 that partially dams the flow of liquid on the stage 132 over a width direction of the stage 132 is provided in a lower portion of the stage 132. The weir 136 may form a water reservoir 139 on the stage 132.

The motor (not illustrated) vibrates the stage 132 so as to flip up a crushed material on the stage 132, specifically, a crushed material having a relatively high specific gravity among the crushed materials, to the upstream side. The amplitude of the vibration applied to the stage 132 may be appropriately set.

The first material group sent from the wind power sorting unit 120 is discharged onto the stage 132 of the specific gravity sorting unit 130, specifically, near the downstream portion of the first passage 133 (region R1 in Fig. 5). In a case where the wind power sorting unit 120 is not provided, all the crushed material crushed by the crushing unit 110 may be sent to the specific gravity sorting unit 130. The specific gravity sorting unit 130 sorts the crushed material crushed by the crushing unit 110 into a first specific gravity material having at least a first specific gravity and a high specific gravity material having a specific gravity larger than the first specific gravity on the basis of specific gravity. More preferably, the specific gravity sorting unit 130 may be configured to sort the crushed material into a first specific gravity material having a first specific gravity, a second specific gravity material having a second specific gravity larger than the first specific gravity, and a third specific gravity material having a third specific gravity larger than the second specific gravity.

The ejection port 138 ejects liquid onto the stage 132 while the specific gravity sorting unit 130 is in operation. With this flow of liquid, a relatively low specific gravity material flows downward and reaches the water reservoir 139 formed by the weir 136.

Among the high specific gravity materials, the third specific gravity material having a relatively high specific gravity moves upward through the first passage 133 of the stage 132 while being slightly flipped up by the vibration of the stage 132 (see arrow A). The third specific gravity material is discharged from an outlet above the stage 132 to the drying unit 140, and then dried in the drying unit 140.

Among the high specific gravity materials, the second specific gravity material having a relatively low specific gravity sinks in the water reservoir 139, and continues to increase in the vicinity of an upper end of the water reservoir 139 due to action of the flow of the liquid and the vibration of the stage 132. When the second specific gravity material increases, the second specific gravity material starts to move upward on the stage 132 from a place where the flow of the liquid is weak due to the action of vibration of the stage 132. Here, the liquid from the ejection port 138 hardly flows through the second passage 134, and hence the second specific gravity material moves upward through the second passage 134 (see arrow B). Thus, the second specific gravity material can be collected separately from the third specific gravity material.

As described above, the stage 132 vibrates with the crushed material placed thereon, whereby the high specific gravity material can be sorted into a second specific gravity material having a second specific gravity larger than the first specific gravity and a third specific gravity material having a third specific gravity larger than the second specific gravity by the vibration of the stage on which the crushed material is placed. Furthermore, as described later, the stage 132 can sort the material in the crushed material into the first specific gravity material, the second specific gravity material, and the third specific gravity material by the vibration of the stage and the action of the liquid described above.

A second weir (not illustrated) extending over a width substantially equal to the width of the first passage 133 may be formed near a downstream end of the partition 135. The second weir may have a height lower than that of the weir 136 described above. In this case, even if the third specific gravity material is flowed to the downstream side of the stage 132, the third specific gravity material is blocked by the second weir, and hence is hardly mixed in the second passage 134. Therefore, the third specific gravity material is likely to move upward through the first passage 133 almost without being mixed into the second passage 134. Further, the second specific gravity material can pass over the second weir having a low height and reach the weir 136, but is easily moved toward the end in the width direction of the stage 132, that is, toward the second passage 134 while being blocked by the weir 136. Thus, the second specific gravity material easily moves upward through the second passage 134 from the end in the width direction of the stage 132. Therefore, in a case where the second weir is provided, there is a possibility that the accuracy of sorting the second specific gravity material and the third specific gravity material increases.

The first specific gravity material floats on an upper surface of the water reservoir 139. The first specific gravity material floating on the upper surface of the water reservoir 139 gets over the weir 136 and the above-described second weir together with the flow of the liquid and then is discharged from the lower end of the stage 132 (see arrow C). Thus, the first specific gravity material can be separately collected from the high specific gravity material (the second specific gravity material and the third specific gravity material).

In the above embodiment, the specific gravity sorting unit 130 is configured to simultaneously sort the first specific gravity material, the second specific gravity material, and the third specific gravity material. Alternatively, the specific gravity sorting unit 130 may separately include a unit for separating the first specific gravity material and the high specific gravity material, and a unit for separating the high specific gravity material into the second specific gravity material and the third specific gravity material. In this case, the unit for separating the first specific gravity material and the high specific gravity material may use, for example, wet specific gravity sorting based on a difference in sedimentation behavior with respect to liquid such as water. The unit for separating the high specific gravity material into the second specific gravity material and the third specific gravity material is not particularly limited, and may be a wet type sorting unit, or may be a dry type sorting unit, for example, using vibration of a stage.

The drying unit 140 may be configured to dry the material sorted by the specific gravity sorting unit 130. In the illustrated aspect, the drying unit 140 is configured to dry the third specific gravity material which is collected through the specific gravity sorting unit 130. Additionally or alternatively, a drying unit for drying the first specific gravity material and/or the second specific gravity material may be provided.

### [Method for collecting material]

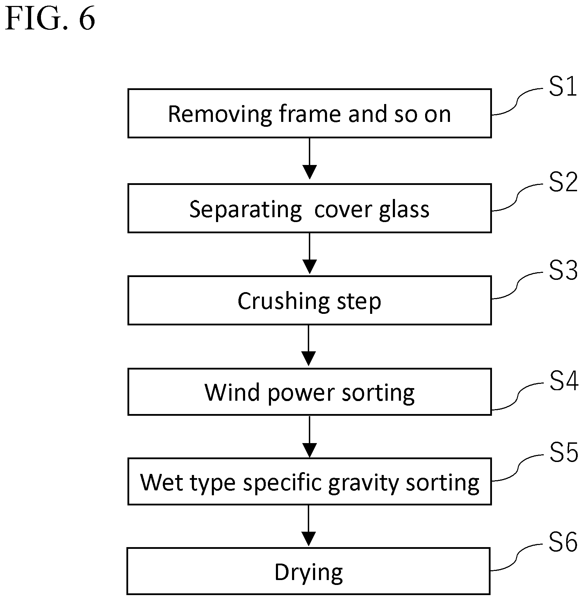

Next, a method for collecting material from a photoelectric conversion panel according to an embodiment will be described with reference to Figs. 3 to 6. Figs. 3 to 5 are as described above. Fig. 6 is a flowchart of a method for collecting material from a photoelectric conversion panel according to the embodiment.

First, the photoelectric conversion module 10 described above is prepared. The photoelectric conversion panel 20 constituting the photoelectric conversion module 10 is preferably a panel containing silicon. Then, a frame 30, a junction box (not illustrated), and the like are removed from the photoelectric conversion module 10 (step S1). Thus, the photoelectric conversion panel 20 is taken out.

Next, a cover glass (glass layer) 23 is removed from the photoelectric conversion panel 20 (step S2). The cover glass 23 is separated from the photoelectric conversion panel 20 by being peeled off. The separated cover glass 23 can be recycled as a glass cullet raw material.

A rear protective layer 22 may be separated from the photoelectric conversion panel 20 if necessary. In this case, the rear protective layer 22 can be recycled as it is in the form of a sheet. Note that the following steps may be executed without separating the rear protective layer 22.

In step S2, a structure in which the cover glass 23, or the cover glass 23 and the rear protective layer 22 are removed from the photoelectric conversion panel 20 is obtained.

Next, the photoelectric conversion panel 20, specifically, the structure subjected to step S2 is crushed (step S3). The method for crushing the structure is not particularly limited. The structure is crushed by, for example, the crushing unit 110 described above. The crushed material formed by crushing the structure may contain a metal material such as copper or silver, silicon, a resin material, or the like.

In step S3, as described above, the structure may be crushed and/or pulverized in two stages using both the first crushing unit 112 and the second crushing unit 115. In other words, step S3 may include both a first crushing step and a second crushing step. The first crushing step is performed by, for example, the first crushing unit 112 described above.

In the second crushing step, the structure crushed by the first crushing unit 112 is further pulverized. In a case where the photoelectric conversion panel includes a photoelectric conversion element having crystalline silicon, the second sealing layer 25 constituting the photoelectric conversion panel is preferably peeled off from the photoelectric conversion element 21 in the second crushing step. The peeling method is not particularly limited. The structure is crushed by, for example, the second crushing unit 115 described above. In the second crushing step, the photoelectric conversion element 21 peeled off from the second sealing layer 25 becomes a pulverized material containing powdery particles which contain a large amount of surface layer portions (the antireflection film 21c and the electrode 21d) and containing particles having a large particle size which contains a large amount of element body portions (the back electrode layer 21a and the silicon crystal layer 21b). That is, silicon is separated into powdery particles having a small particle size and particles having a larger particle size than the powdery particles.

In a case where the photoelectric conversion panel includes a photoelectric conversion element having crystalline silicon, silicon is easily separated into powdery particles having a small particle size and particles having a larger particle size than the powdery particles. In particular, bending strength of the material used for the antireflection film 21c, for example, SiO₂ and SiN is about 1/3 of bending strength of silicon. Furthermore, a thermal expansion coefficient of these materials used for the antireflection film 21c is about 1/10 of a thermal expansion coefficient of silicon. Therefore, a large stress is applied to the antireflection film 21c, and brittleness of the antireflection film 21c is considered to be extremely low as compared with silicon. Thus, the inventor has found that when mechanical pressure, that is, crushing processing is applied, the antireflection film 21c formed on silicon and the electrode 21d formed thereon tend to peel off as powdery particles having a small particle size. Thus, the material having an intermediate specific gravity material (the same or similar material as the second specific gravity material), here, silicon is pulverized separately into powdery particles mainly having a small particle diameter and particles having a particle diameter larger than that of the powder.

Next, a wind power sorting step S4 is performed if necessary. The wind used in the wind power sorting step S4 may be a spiral wind. In the wind power sorting step S4, the pulverized material formed by pulverizing the structure is sorted, by the wind power, into a first material group used in a specific gravity sorting step S5 to be described later and a second material group not used in the specific gravity sorting step S5. The crushed material is sorted by the wind power on the basis of the weight and volume of the material in the crushed material. Specifically, in the wind power sorting step S4, the crushed material is sorted by the wind power on the basis of the weight and volume of the material in the crushed material. The first material group includes a material having a relatively large particle size and a relatively large specific gravity, and the second material group includes particles having a relatively small particle size (powder state).

In a case where the photoelectric conversion panel includes a photoelectric conversion element having crystalline silicon, in step S3, a material having an intermediate specific gravity material (a material having the same or similar specific gravity as the second specific gravity material), here, silicon is pulverized separately into powdery particles mainly having a small particle size and particles having a particle size larger than the powder. In the wind power sorting step S4, the powdery particles having a small particle size, that is, powdery silicon particles can be collected as the second material group. In this case, in the wind power sorting step S4, it is preferable to adjust the strength of the wind power so that the material having the intermediate specific gravity, here, silicon, is collected as the second material group.

Next, the specific gravity sorting step S5 of sorting the crushed material is performed. In the specific gravity sorting step S5, the crushed material is sorted into a first specific gravity material having at least the first specific gravity and a high specific gravity material having a specific gravity larger than the first specific gravity on the basis of specific gravity. Preferably, in the specific gravity sorting step, the crushed material is sorted into a first specific gravity material, a second specific gravity material having a second specific gravity larger than the first specific gravity, and a third specific gravity material having a third specific gravity larger than the second specific gravity on the basis of the specific gravity. As described above, the sorting based on these specific gravities can be performed on the basis of at least one, preferably both, of a difference in sedimentation behavior of a material in the crushed material with respect to liquid and a vibration of a stage on which the crushed material is placed. Preferably, as described with reference to Figs. 4 to 5, the specific gravity sorting step S5 includes separating the first specific gravity material, the second specific gravity material, and the third specific gravity material by vibrating the stage while causing the liquid to flow through the inclined stage on which the crushed material is placed.

Next, the material sorted by the specific gravity sorting unit, that is, the first specific gravity material, the second specific gravity material, and/or the third specific gravity material is dried if necessary (step S6). In the present embodiment, the third specific gravity material is dried by the drying unit 140. Additionally, the first specific gravity material and/or the second specific gravity material may also be dried if necessary.

In the case of the silicon-based photoelectric conversion panel 20, the photoelectric conversion panel 20 often contains silicon, a metal material such as copper and silver, and a resin material. In this case, the third specific gravity material mainly contains a metal material such as copper. Since copper has a higher specific gravity than other materials, copper can be selectively contained into the third specific gravity material. Therefore, this method for collecting can provide high collection efficiency for copper. The second specific gravity material mainly contains silicon particles. Since silicon has a specific gravity lower than that of copper, silicon is easily contained in the second specific gravity material. Therefore, this method for collecting can also be suitable for collection and recycling of silicon particles. The first specific gravity material mainly contains a large amount of a resin material.

As described above, the inventor of the present application has found that, in a case where the photoelectric conversion panel includes a photoelectric conversion element having crystalline silicon, the second material group sorted in the wind power sorting step S4 contains a large amount of powdery silicon generated by crushing in step S3, and that the powdery silicon is mainly a pulverized material of surface layer portions (antireflection film 21c and electrode 21d) of the photoelectric conversion element 21. Since the electrode 21d located in the surface layer portion of the photoelectric conversion element 21 contains silver, powdery silicon and silver are mixed. On the other hand, since silicon having a particle size larger than that of powdery silicon is considered to be mainly derived from the silicon crystal layer 21b, the amount of silver contained in silicon having a large particle size is considered to be relatively low. In the above aspect, by the wind power sorting step S4, powdery silicon having a relatively high silver content can be collected separately from silicon having a relatively low silver content and having a relatively large particle size. Thus, silicon can be efficiently sorted and collected.

Some organic substances pulverized into powder form are also contained in the powdery silicon sorted in the wind power sorting step S4. Therefore, specific gravity separation or sieving may be performed to the powdery silicon (second material group) if necessary. Thus, the organic substance can be removed from the powdery silicon, or from the second material group.

According to the method for collecting material, materials such as copper and silicon can be collected in a solid state without using an etching solution such as nitric acid. Further, a metal material such as copper, silicon, and a resin material can be separately collected by the specific gravity sorting step S5. In particular, by using the wind power sorting step S4 and the specific gravity sorting step S5 in combination, it is also possible to sort a metal material such as copper with high purity.

The second material group collected in the wind power sorting step S4 may include a material that is the same as a material mainly contained in the second specific gravity material sorted in the specific gravity sorting step S5, and that may have a smaller particle size than the material mainly contained in the second specific gravity material. This material corresponds to silicon when the photoelectric conversion panel includes a photoelectric conversion element having crystalline silicon. As described above, the powdery material having a small particle size can be individually collected by additionally using the wind power sorting step S4 in addition to the specific gravity sorting. It should be noted that this is not limited to the case where the photoelectric conversion panel is crystalline silicon, and may similarly apply in a case where the same material is pulverized into pulverized materials of different particle sizes.

### [Examples]

The material was collected from the photoelectric conversion panel 20 by the system and the method for collecting material described above. In the present Example, a material was collected from a silicon-based solar cell panel, specifically, a structure obtained by removing the cover glass 23 and the rear protective layer 22 from a solar cell panel, using the system illustrated in Figs. 3 to 5. Specifically, the crushed material was sorted into the second material group, the first specific gravity material, the second specific gravity material, and the third specific gravity material by the wind power sorting step S4 and the specific gravity sorting step S5. In the specific gravity sorting step S5, the inclination of the stage 132 was 4°, and the frequency of the stage 132 was 49 Hz.

Results of measuring contents of copper, silver, silicon, and lead contained in each of the second material group, the second specific gravity material, and the third specific gravity material are illustrated in Table 1 below.

**(Table 1)**

| | Copper | Silver | Silicon | Lead | Resin material |
|---|---|---|---|---|---|
| Second material group | 0.16% | 2.61% | 60.43% | 0.78% | 30.26% |
| First specific gravity material | 0.00% | 0.15% | 12.20% | 0.10% | 84.73% |
| Second specific gravity material | 0.99% | 1.54% | 92.17% | 0.45% | 0.81% |

From the results illustrated in Table 1, it can be seen that the second material group mainly contains silicon and a resin material. The silicon contained in the second material group was powdery fine particles. Since powdery silicon has a large difference in specific gravity from the mixed resin material, the powdery silicon can be easily sorted again by specific gravity separation or sieving if necessary.

The first specific gravity material sorted in the specific gravity sorting step S5 mainly contained a resin material. The first specific gravity material can be recycled by being mixed into asphalt or concrete. Note that, since the ratio of silicon and the metal material contained in the first specific gravity material is small, it is found that silicon and the metal material can be collected to another group with relatively high purity.

The second specific gravity material sorted in the specific gravity sorting step S5 mainly contains silicon. The resin material contained in the second specific gravity material is less than 1%, and the ratio of silicon contained in the second specific gravity material exceeds 90%. As described above, silicon having a relatively large particle diameter could be collected with high purity.

Further, the third specific gravity material sorted in the specific gravity sorting step S5 mainly contained copper. The ratio of the resin material contained in the third specific gravity material was equal to or less than the measurement limit value (almost 0%). Therefore, it was found that copper can be collected with high purity.

Silicon is contained in a large amount in both the second material group and the second specific gravity material. However, the average particle diameter of silicon contained in the second material group is smaller than the average particle diameter of silicon contained in the second specific gravity material. As described above, in this method for collecting in the present invention, silicon having different average particle diameters can be separately collected.

Table 2 below illustrates results of measuring which of the second material group, the first specific gravity material, the second specific gravity material, and the third specific gravity material silver contained in the photoelectric conversion panel 20 was sorted.

**(Table 2)**

| | Amount of silver |
|---|---|
| Second material group | 59.09% |
| First specific gravity material | 4.55% |
| Second specific gravity material | 36.36% |
| Third specific gravity material | 0.00% |
| Total | 100.00% |

From the results illustrated in Table 2, it was found that silver was mainly contained in the second specific gravity material and the second material group which are suitable for refining. The amount of silver contained in the second material group and the second specific gravity material was 95.45% of the total amount of silver. Here, silver can be collected by about 80% by immersion for 5 minutes in an another etching technical using nitric acid. Therefore, it can be seen that the method for collecting material in the present invention can collect silver in a higher yield as compared with etching using nitric acid.

As described above, the contents of the present invention have been disclosed through the embodiments, but it should not be understood that the description and the drawings constituting a part of the disclosure limit the present invention. From this disclosure, various alternative embodiments, examples, and operational techniques will become apparent to those skilled in the art. Therefore, the technical scope of the present invention is defined only by the matters specifying the invention according to the claims appropriate from the above description.

This application claims priority based on Japanese Patent Application No. 2022-011587 filed on January 28, 2022, the entire contents of which are incorporated herein by reference.

## Claims

1. A method for collecting a material from a photoelectric conversion panel, comprising:
a crushing step of forming a crushed material by crushing a structure constituting a photoelectric conversion panel; and
a specific gravity sorting step of sorting the crushed material into a first specific gravity material having at least a first specific gravity and a high specific gravity material having a specific gravity larger than the first specific gravity on a basis of specific gravity.

2. The method for collecting a material from a photoelectric conversion panel according to claim 1, wherein the specific gravity sorting step includes sorting the crushed material into the first specific gravity material, a second specific gravity material having a second specific gravity larger than the first specific gravity, and a third specific gravity material having a third specific gravity larger than the second specific gravity.

3. The method for collecting a material from a photoelectric conversion panel according to claim 1 or 2, wherein the specific gravity sorting step includes sorting the crushed material on a basis of at least one of a difference in sedimentation behavior of a material in the crushed material with respect to liquid and a vibration of a stage on which the crushed material is placed.

4. The method for collecting a material from a photoelectric conversion panel according to any one of claims 1 to 3, further comprising a wind power sorting step of sorting the crushed material into a first material group and a second material group lighter than the first material group by wind power, the first material group be used in the specific gravity sorting step, and the second material group be not used in the specific gravity sorting step.

5. The method for collecting a material from a photoelectric conversion panel according to claim 2, further comprising a wind power sorting step of sorting the crushed material into a first material group and a second material group lighter than the first material group by wind power, the first material group be used in the specific gravity sorting step, and the second material group be not used in the specific gravity sorting step, wherein
the second material group includes a material that is same as a material mainly contained in the second specific gravity material, and has a smaller particle size than the material mainly contained in the second specific gravity material.

6. The method for collecting a material from a photoelectric conversion panel according to claim 2 or 5, wherein
the photoelectric conversion panel includes a metal containing at least copper, silicon, and a resin, and
the second specific gravity material mainly contains silicon, and
the third specific gravity material mainly contains copper.

7. The method for collecting a material from a photoelectric conversion panel according to any one of claims 1 to 6, further comprising a step of removing a glass layer from the photoelectric conversion panel before the crushing step.

8. A system for collecting a material from a photoelectric conversion panel, comprising:
a crushing unit that is configured to form a crushed material by crushing a structure constituting a photoelectric conversion panel; and
a specific gravity sorting unit that is configured to sort the crushed material into a first specific gravity material having at least a first specific gravity and a high specific gravity material having a specific gravity larger than the first specific gravity on a basis of specific gravity.

9. The system for collecting a material from a photoelectric conversion panel according to claim 8, wherein the specific gravity sorting unit is configured to sort the crushed material into the first specific gravity material, a second specific gravity material having a second specific gravity larger than the first specific gravity, and a third specific gravity material having a third specific gravity larger than the second specific gravity.

10. The system for collecting a material from a photoelectric conversion panel according to claim 8 or 9, wherein the specific gravity sorting unit includes an ejection port that ejects liquid for sorting a material in the crushed material on a basis of a difference in sedimentation behavior.

11. The system for collecting a material from a photoelectric conversion panel according to any one of claims 8 to 10, further comprising a wind power sorting unit that is configured to sort the crushed material into a first material group and a second material group lighter than the first material group by wind power, said first material group be used in the specific gravity sorting unit, said second material group be not used in the specific gravity sorting unit.

12. The system for collecting a material from a photoelectric conversion panel according to claim 11, wherein the wind power sorting unit includes a cyclone-type wind power sorter that is configured to sort a material having a small particle size from the crushed material.

13. The system for collecting a material from a photoelectric conversion panel according to claim 9, comprising a stage capable of vibrating so as to sort a material in the crushed material into the first specific gravity material, the second specific gravity material and the third specific gravity material.

14. The system for collecting a material from a photoelectric conversion panel according to any one of claims 8 to 13, comprising a drying unit that is configured to dries a material sorted by the specific gravity sorting unit.
